# EUROPÄISCHE PATENTANMELDUNG

(11) **EP 3 232 750 A1**
(43) Veröffentlichungstag der Anmeldung: **18.10.2017**
(21) Anmeldenummer: 16165363.9
(22) Anmeldetag: 14.04.2016
(51) Int. Cl.: H05K 7/14, H05K 7/20

(54) **SYSTEM UND VERFAHREN ZUM KÜHLEN VON RECHENVORRICHTUNGEN**

(71) Anmelder: noris network AG, 90471 Nürnberg (DE)
(72) Erfinder: FISCHER, Thomas, 90443 Nürnberg (DE); SIPPEL, Florian, 90425 Nürnberg (DE)
(74) Vertreter: Karl, Christof

(57) **Zusammenfassung**

Die Erfindung betrifft ein System und Verfahren zum Kühlen von Rechenvorrichtungen. Das System ist dazu eingerichtet, einen Luftstrom zwischen einer Kühlluftquelle, einer ersten Menge von Rechenvorrichtungen und einer zweiten Menge von Rechenvorrichtungen zu erzeugen. Dabei wird durch die Kühlluftquelle Luft mit einer ersten Temperatur ausgegeben, mit der die erste Menge von Rechenvorrichtungen gekühlt wird, wobei mindestens ein Teil der durch die Kühlluftquelle ausgegebenen Luft in die erste Menge von Rechenvorrichtungen eingegeben wird und von der ersten Menge von Rechenvorrichtungen aufgeheizt und in einen Raum mit Luft mit einer zweiten Temperatur ausgegeben wird. Diese zweite Temperatur ist höher als die erste Temperatur. Die zweite Menge von Rechenvorrichtungen wird dann mit Luft aus dem Raum mit der Luft mit der zweiten Temperatur gekühlt, wobei mindestens ein Teil der Luft aus dem Raum mit der Luft mit der zweiten Temperatur in die zweite Menge von Rechenvorrichtungen eingegeben und von der zweiten Menge von Rechenvorrichtungen aufgeheizt und ausgegeben wird.

## Beschreibung

### Gebiet

Die Erfindung bezieht sich auf ein verbessertes Kühlsystem für Rechenzentren. Insbesondere bezieht sich die Erfindung auf die Kühlung von Rechenvorrichtungen mit Luft, die vorher bereits zur Kühlung von anderen Rechenvorrichtungen verwendet wurde. Rechenvorrichtungen beziehen sich hierbei zum Beispiel auf Server, Netzwerk-Geräte, Speicher-Systeme und andere IT-Geräte, die üblicherweise in einem Rechenzentrum betrieben werden. Ein Einsatzgebiet für die Erfindung besteht beispielsweise bei moderneren Servern, welche eine Kühlung durch Luft mit höherer Temperatur erlauben. Auch betrifft die Erfindung eine innovative Anordnung von Rechenvorrichtungen, welche Vorteile bei einer Integration in Rechenzentren bietet.

### Hintergrund/Stand der Technik

Die Kühlung ist für den größten Teil des Energieverbrauchs in einem Rechenzentrum verantwortlich. Zur Kühlung eines Rechenzentrums können passive und/oder aktive Kühltechniken in den Kühlsystemen eingesetzt werden. Eine aktive Kühltechnik beinhaltet beispielsweise eine Kompressionskühlung, auch maschinelle Kühlung genannt. Bei einer passiven Kühltechnik, welche auch freie Kühlung genannt wird, unterscheidet man zwischen einer direkten und einer indirekten Kühlung. Bei der direkten Kühlung wird das Rechenzentrum beispielsweise mithilfe von Außenluft gekühlt, welche von einem Kühlsystem angesaugt wird, durch das Rechenzentrum und die entsprechenden Rechenkomponenten geleitet wird und anschließend wieder in die Außenluft abgegeben wird. Die indirekte Kühlung hingegen weist einen geschlossenen Kühlkreislauf auf, wobei dieser mithilfe von Wärmetauschern, die in Verbindung mit der Außenluft oder einem Wasserkühlkreislauf stehen, gekühlt wird. In der Regel sind indirekte freie Kühlungen ineffizienter als direkte freie Kühlungen, da durch den Wärmetauscher Leistung verloren geht. Der Wärmetauscher kann beispielsweise die zu kühlende Luft nicht bis auf die Temperatur der Außenluft herunterkühlen, sondern sich dieser lediglich auf einige Grade annähern. Allerdings hat eine indirekte Kühlung den Vorteil, dass der geschlossene Kreislauf es ermöglicht, das Klima innerhalb des Rechenzentrums zu kontrollieren. Anders ausgedrückt, Kühlluft bereitzustellen, die frei von Verunreinigungen ist, wie beispielsweise Feinstaub und Abgasen, und eine geregelte Luftfeuchtigkeit aufweist. Ein Beispiel für eine solche indirekte freie Kühlung ist ein rotierender Wärmetauscher. Rechenzentren können sowohl mit einer passiven als auch einer aktiven Kühltechnik ausgerüstet sein, um einen durchgängigen Betrieb unabhängig von der Außentemperatur oder der Temperatur einer Wasserquelle zu gewährleisten. In einem solchen Fall wird die aktive Kühltechnik lediglich verwendet, wenn die passive Kühlung nicht ausreicht, um die gewünschte Kühltemperatur zu erreichen. Allgemein ist es vorteilhaft, eine passive Kühlung einzusetzen, da diese weniger Energie als eine aktive Kühlung verbraucht. Somit kann beispielsweise dadurch Energie eingespart werden, dass ein Betrieb einer passiven Kühlung für einen möglichst langen Zeitraum, bevorzugt durchgehend, ermöglicht wird.

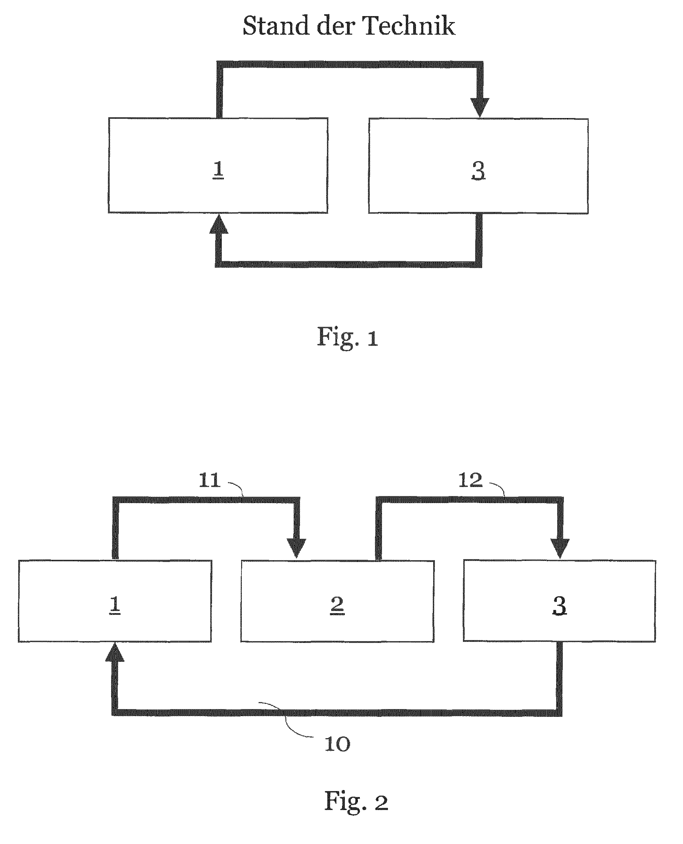

Im Falle einer indirekten freien Kühlung hat ein Rechenzentrum zwei Wärmetauschabschnitte, wobei sich einer in der Rechenvorrichtung befindet und typischerweise als Kühlkörper bezeichnet wird. Der andere Wärmetauschabschnitt in dem Kühlsystem wird traditionell als Kühlregister bezeichnet. Eine Rechenvorrichtung in einem Rechenzentrum kann als eine Vorrichtung angesehen werden, welche elektrische Energie in Wärme umwandelt. Der Wärmetauschabschnitt in der Rechenvorrichtung ermöglicht es, ihre elektronischen Komponenten zu kühlen, wohingegen der Wärmetauschabschnitt des Kühlsystems die von der Rechenvorrichtung kommende warme Luft kühlt. Hintereinander geschaltet ergeben die beiden Kühlabschnitte einen Kühlkreislauf, wie er in Fig. 1 veranschaulicht wird.

Fig. 1 zeigt eine schematische Darstellung eines im Stand der Technik verwendeten indirekten Kühlverfahrens, wobei ein Kreislauf zwischen einer ersten Menge von Rechenvorrichtungen 1 und einer Kühlluftquelle 3 veranschaulicht ist. Die Kühlluftquelle 3 gibt Kühlluft aus, welche zu der ersten Menge von Rechenvorrichtungen 1 geleitet wird und in diese eingegeben wird. Die Kühlluft kühlt die erste Menge von Rechenvorrichtungen 1, wobei sie aufgeheizt wird. Sie wird dann zurück an die Kühlluftquelle 3 geleitet, die sie wieder abkühlt.

Wie eingangs erwähnt, haben die bekannten Kühlsysteme für Rechenzentren aber einen unerwünscht hohen Energiebedarf. Aufgabe dieser Erfindung ist es daher, ein Kühlsystem für Rechenzentren bereitzustellen welches einen geringeren Energiebedarf aufweist. Insbesondere stellt diese Erfindung eine effizientere indirekte Kühlung bereit.

### Zusammenfassung der Erfindung

Die Erfindung betrifft ein System zum Kühlen von Rechenvorrichtungen, welches dazu eingerichtet ist, einen Luftstrom zwischen einer Kühlluftquelle, einer ersten Menge von Rechenvorrichtungen und einer zweiten Menge von Rechenvorrichtungen zu erzeugen. Dabei wird durch die Kühlluftquelle Luft mit einer ersten Temperatur ausgegeben, mit der die erste Menge von Rechenvorrichtungen gekühlt wird, wobei mindestens ein Teil der durch die Kühlluftquelle ausgegebenen Luft in die erste Menge von Rechenvorrichtungen eingegeben wird und von der ersten Menge von Rechenvorrichtungen aufgeheizt und in einen Raum mit Luft mit einer zweiten Temperatur ausgegeben wird. Diese zweite Temperatur ist höher als die erste Temperatur. Die zweite Menge von Rechenvorrichtungen wird dann mit Luft aus dem Raum mit der Luft mit der zweiten Temperatur gekühlt, wobei mindestens ein Teil der Luft aus dem Raum mit der Luft mit der zweiten Temperatur in die zweite Menge von Rechenvorrichtungen eingegeben und von der zweiten Menge von Rechenvorrichtungen aufgeheizt und ausgegeben wird.

Demnach verwendet das erfindungsgemäße System Luft, welche bereits bei der Kühlung einer ersten Menge von Rechenvorrichtungen aufgeheizt wurde, zur Kühlung einer zweiten Menge von Rechenvorrichtungen.

Die durch die Kühlung der zweiten Menge von Rechenvorrichtungen weiter erhöhte Lufttemperatur führt in der Regel zu einem größeren Temperaturunterschied zwischen der Temperatur der Kühlluftquelle, welche je nach Kühlverfahren von der Außenluft oder einer Wasserquelle abhängt, und der durch die zweite Menge von Rechenvorrichtungen abgegebenen, vom Wärmetauscher des Kühlsystems zu kühlenden Luft. Damit kann die Wirkung des Wärmetauschers verbessert und der Energieverbrauch eines Rechenzentrums verringert werden.

Die Kühlung einer zweiten Menge von Rechenvorrichtungen mit der Abluft einer ersten Menge von Rechenvorrichtungen hat zudem den Vorteil, dass erstens weniger Luftvolumen bewegt werden muss und zweitens weniger Luftvolumen auf die Temperatur, welche von der ersten Menge von Rechenvorrichtungen gefordert wird, gekühlt werden muss. Im Detail muss also durch die hintereinandergestellte Anordnung der Rechenvorrichtungen weniger Volumen an Luft in dem Rechenzentrum bewegt werden, als in konventionellen Rechenzentren, in denen alle Rechenvorrichtungen der ersten Menge von Rechenvorrichtungen zugeordnet sind. Durch eine geringere Anzahl an Rechenvorrichtungen in der ersten Menge von Rechenvorrichtungen wird weniger Luft benötigt, welche den Temperaturerfordernissen der ersten Menge von Rechenvorrichtungen genügt, und somit Energie eingespart. Es werden nämlich vorteilhaft vor allem solche Rechenvorrichtungen der ersten Menge von Rechenvorrichtungen zugeordnet, die entsprechend hohe Anforderungen an die zugeführte Kühlluft haben, d.h. Luft mit einer entsprechend geringen Temperatur zur Kühlung benötigen.

Unter dem Begriff Rechenvorrichtung ist vorliegend jede Rechenvorrichtung zu verstehen, die in einem Rechenzentrum angeordnet sein kann und auf welcher ein Computerprogramm ausgeführt werden kann. Insbesondere, aber nicht ausschließlich, kann eine Rechenvorrichtung eines der folgenden sein: ein Server, ein Router, ein Switch, eine Speichervorrichtung, eine Netzwerkkomponente und jedes andere IT-Gerät, das in einem Rechenzentrum verwendet wird. In der Regel umfassen die in Rechenzentren untergebrachten Rechenvorrichtungen jeweils ein eigenes Gehäuse und einen eigenen Ventilator, dessen Leistung typischerweise in Abhängigkeit des Kühlbedarfs regelbar ist.

Die Eingabe und Ausgabe von Luft in und aus Rechenvorrichtungen oder Kühlluftquellen beinhaltet jede Art der Ein- und Ausgabe, wie beispielsweise Ansaugen und Ausstoßen von Luft durch den eigenen Ventilator der Rechenvorrichtung. Zu berücksichtigen ist, dass die Temperatur der Luft in dem oben beschriebenen "Raum mit Luft mit einer zweiten Temperatur" nicht notwendigerweise in dem gesamten Raum gleich sein muss. Sie kann je nach Nähe zu einer wärmeabgebenden Komponente einer Rechenvorrichtung oder je nach Mischung unterschiedlicher Luftströme in dem Raum variieren. Mit der zweiten Temperatur, die in dem Raum vorherrscht, ist dementsprechend die Durchschnittstemperatur der Luft in dem Raum gemeint.

Vorzugsweise umfasst das System eine dritte Menge von Rechenvorrichtungen, wobei mindestens ein Teil der von der zweiten Menge von Rechenvorrichtungen aufgeheizten Luft in einen Raum mit Luft mit einer dritten Temperatur ausgegeben wird, welche höher als die zweite Temperatur ist. Das System ist dazu eingerichtet, die dritte Menge von Rechenvorrichtungen mit Luft aus dem Raum mit der Luft mit der dritten Temperatur zu kühlen, wobei mindestens ein Teil der Luft aus dem Raum mit der Luft mit der dritten Temperatur in die dritte Menge von Rechenvorrichtungen eingegeben und von der dritten Menge von Rechenvorrichtungen aufgeheizt und ausgegeben wird.

Wie oben beschrieben kann das System zum Kühlen von Rechenvorrichtungen mehr als zwei Mengen von Rechenvorrichtungen, also mehr als zwei Stufen, aufweisen. Die mögliche Anzahl der Stufen hängt ab von der Temperatur der Luft, die die Kühlluftquelle ausgibt, von der maximalen Temperatur, mit der wenigstens ein Teil der Rechenvorrichtungen noch gekühlt werden kann, und von dem Temperaturunterschied um den die Rechenvorrichtungen die Luft jeweils aufheizen. Die Wahl eines zweistufigen oder mehrstufigen Systems kann von den gewünschten Anwendungsszenarien abhängen. Stehen beispielsweise Rechenvorrichtungen mit drei unterschiedlichen Temperaturerfordernissen zur Verfügung, ist es sinnvoll ein dreistufiges System zu wählen, um eine möglichst effektive Kühlung zu erhalten.

Vorzugsweise ist das System dazu eingerichtet, mindestens einen Teil der von der zweiten und/oder, falls vorhanden der dritten Menge von Rechenvorrichtungen aufgeheizten und ausgegebenen Luft zurück zur Kühlluftquelle zu leiten. Vorzugsweise, wird mindestens ein Teil der zurück zur Kühlluftquelle geleiteten Luft durch die Kühlluftquelle gekühlt.

Durch das Zurückführen von mindestens einem Teil der Abluft aus der letzten Menge von Rechenvorrichtungen, welches je nach Szenario die zweite, dritte oder eine andere Menge von Rechenvorrichtungen sein kann, zurück an eine oder mehrere Kühlluftquellen kann der Kühlkreislauf geschlossen werden. Wie eingangs erwähnt hat die Verwendung eines geschlossenen Kühlkreislaufs den Vorteil, dass die Luftfeuchtigkeit leicht geregelt werden kann und dass keine Verunreinigungen, welche sich beispielsweise in der Außenluft befinden können, in die Kühlluft eindringen können. Somit kann eine konstante Luftqualität der Kühlluft gewährleistet werden.

Die oben beschriebenen Systeme führen bei ihrem Betrieb ein Verfahren zum Kühlen von Rechenvorrichtungen durch, umfassend: Ausgeben von Luft mit einer ersten Temperatur durch eine Kühlluftquelle, Kühlen einer ersten Menge von Rechenvorrichtungen mit durch die Kühlluftquelle ausgegebener Luft, wobei mindestens ein Teil der durch die Kühlluftquelle ausgegebenen Luft in die erste Menge von Rechenvorrichtungen eingegeben wird und von der ersten Menge von Rechenvorrichtungen aufgeheizt und in einen Raum mit Luft mit einer zweiten Temperatur ausgegeben wird, welche höher als die erste Temperatur ist und Kühlen einer zweiten Menge von Rechenvorrichtungen mit Luft aus dem Raum mit der Luft mit der zweiten Temperatur, wobei mindestens ein Teil der Luft aus dem Raum mit der Luft mit der zweiten Temperatur in die zweite Menge von Rechenvorrichtungen eingegeben und von der zweiten Menge von Rechenvorrichtungen aufgeheizt und ausgegeben wird.

Vorzugsweise wird mindestens ein Teil der von der zweiten Menge von Rechenvorrichtungen aufgeheizten Luft in einen Raum mit Luft mit einer dritten Temperatur ausgegeben, welche höher als die zweite Temperatur ist und das Verfahren umfasst vorzugsweise ferner: Kühlen einer dritten Menge von Rechenvorrichtungen mit Luft aus dem Raum mit der Luft mit der dritten Temperatur, wobei mindestens ein Teil der Luft aus dem Raum mit der Luft mit der dritten Temperatur in die dritte Menge von Rechenvorrichtungen eingegeben und von der dritten Menge von Rechenvorrichtungen aufgeheizt und ausgegeben wird.

Vorzugsweise wird mindestens ein Teil der von der zweiten und/oder falls vorhanden der dritten Menge von Rechenvorrichtungen aufgeheizten und ausgegebenen Luft zurück zur Kühlluftquelle geleitet.

Das erfindungsgemäße Verfahren ist besonders vorteilhaft, wenn mindestens eine der Rechenvorrichtungen aus der ersten Menge von Rechenvorrichtungen eine Kühlung mit Luft mit geringerer Temperatur als erfordert als die Rechenvorrichtungen aus der zweiten Menge von Rechenvorrichtungen.

Aufgrund dieser unterschiedlichen Erfordernisse von Rechenvorrichtungen oder gegebenenfalls Komponenten kann ein Kühlstrom möglichst effizient ausgenutzt werden, indem zuerst die Rechenvorrichtungen und/oder Komponenten mit den hohen Anforderungen an die Kühltemperatur und anschließend die Rechenvorrichtungen und/oder Komponenten mit niedrigeren Anforderungen gekühlt werden.

Typischerweise erfordert mindestens eine aus der ersten Menge von Rechenvorrichtungen eine Kühlung mit Luft mit einer Temperatur von höchstens 30°C, bevorzugt von höchstens 25°C und am meisten bevorzugt von höchstens 20°C.

Vorzugsweise erfordert mindestens eine Rechenvorrichtung aus der ersten Menge von Rechenvorrichtungen eine Kühlung mit Luft mit einer Temperatur, die mindestens 2 °C, bevorzugt mindestens 4 °C, noch weiter bevorzugt mindestens 6 °C und am meisten bevorzugt mindestens 10 °C geringer ist, als die maximale Temperatur der Luft, mit der alle der Rechenvorrichtungen der zweiten Menge von Rechenvorrichtungen gekühlt werden können.

Die erste, zweite, dritte und/oder jede nachfolgende Menge von Rechenvorrichtungen kann aus nur einer Rechenvorrichtung bestehen; typischerweise wird sie aber mehrere Rechenvorrichtungen umfassen. Jede der hier erwähnten Mengen von Rechenvorrichtungen ist demnach nicht auf eine Mehrzahl von Rechenvorrichtungen beschränkt, sondern kann auch lediglich eine einzige Rechenvorrichtung umfassen.

Vorzugsweise ist die erste, zweite, dritte und/oder jede nachfolgende Menge von Rechenvorrichtungen jeweils in einem Serverschrank angeordnet.

In der Regel sind in Rechenzentren Rechenvorrichtungen in Serverschränken angeordnet. Unter einem Serverschrank ist jede Art von Schrank, Rack und/oder Regal zu verstehen, welcher/welches in der Lage ist, eine oder mehrere Rechenvorrichtungen aufzunehmen. Ein Serverschrank ist bevorzugt so abgedichtet, dass Luft nur über die definierten Lufteinlässe, die Rechenvorrichtungen typischerweise aufweisen, in diese eindringen und über deren definierte Luftauslässe diese verlassen können. Ein Serverschrank stellt daher sicher, dass möglichst keine Luft an den Rechenvorrichtungen vorbei durch den Serverschrank strömt. Die Serverschränke werden traditionell in Reihen aufgestellt, wobei die Reihen jeweils in Gruppen von zwei Reihen aufgeteilt sind, in denen die Serverschränke so angeordnet sind, dass die Rückseiten der Serverschränke sich gegenüberstehen. Diese bilden somit einen Teil einer Warmgangeinhausung, in welche die Rechenvorrichtungen erhitzte Luft ausgeben, welche dann beispielsweise in die Außenluft oder zu der Kühlluftquelle geführt werden kann. Unter einem Warmgang versteht man in einem Rechenzentrum einen Raum, in den die warme Abluft der Rechenvorrichtungen abgegeben wird. Die Warmgangeinhausung entspricht somit der Umhüllung dieses Warmgangs.

Vorzugsweise ist/sind eine, mehrere, oder bevorzugt alle Rechenvorrichtungen aus der ersten, zweiten, dritten und/oder jeder nachfolgenden Menge von Rechenvorrichtungen jeweils in einem eigenen Gehäuse angeordnet.

Jede Rechenvorrichtung kann ein eigenes Gehäuse aufweisen, in welchem bestimmte Temperaturerfordernisse für eine jeweilige Rechenvorrichtung erfüllt sein müssen.

Vorzugsweise weist ein Gehäuse jeweils einen Lufteinlass und einen Luftauslass auf.

Jedes Gehäuse, in dem eine Rechenvorrichtung angeordnet ist, besitzt einen Lufteinlass und ein Luftauslass, um einen entsprechenden Luftstrom in dem Gehäuse zu ermöglichen.

Vorzugsweise weist/weisen eine, mehrere, oder bevorzugt alle Rechenvorrichtungen aus der ersten, zweiten, dritten und/oder jeder nachfolgenden Menge von Rechenvorrichtungen jeweils einen eigenen Ventilator auf.

Die Integration eines Ventilators in jede Rechenvorrichtung bietet den Vorteil, dass jede Rechenvorrichtung zu dem gesamten Luftstrom beitragen kann, so dass der Luftstrom nicht alleine durch die Kühlluftquelle erzeugt werden muss. Somit kann ein gleichmäßiger Luftstrom durch einen Serverschrank und/oder ein Rechenzentrum hindurch ermöglicht werden.

Vorzugsweise werden die Ventilatoren durch die entsprechende Rechenvorrichtung selbst geregelt.

Dies bietet den Vorteil, dass die Rechenvorrichtung den Ventilator je nach Bedarf steuern kann und somit ein starker Luftstrom nur dann erzeugt wird, wenn dieser auch benötigt wird. Die Kühlluftquelle kann so eingerichtet sein, dass sie auf den Bedarf der einzelnen Ventilatoren reagiert, indem sie beispielsweise einen durch diese erzeugten Unter- oder Überdruck ausgleicht. Indem die Kühlluftquelle auf die einzelnen Ventilatoren reagiert, wird weiter Energie eingespart, da die Kühlluftquelle lediglich einen von den Ventilatoren benötigten Luftstrom bereitstellen muss.

Vorzugsweise ist die zweite Menge von Rechenvorrichtungen oberhalb der ersten Menge von Rechenvorrichtungen angeordnet. In diesem Fall weist der Luftstrom von der ersten Menge von Rechenvorrichtungen zu der zweiten Menge von Rechenvorrichtungen eine vertikale Flussrichtung auf.

Eine solche Anordnung ist vorteilhaft, da dadurch der Raum über traditionellen Serverschränken möglichst effektiv verwendet werden kann.

In einer anderen Ausführungsform ist die zweite Menge von Rechenvorrichtungen in horizontaler Richtung neben der ersten Menge von Rechenvorrichtungen angeordnet. In diesem Fall weist der Luftstrom von der ersten Menge von Rechenvorrichtungen zu der zweiten Menge von Rechenvorrichtungen eine horizontale Flussrichtung auf.

Eine solche Anordnung kann vorteilhaft sein, wenn beispielsweise ein Ausbau in eine vertikale Richtung nicht möglich ist.

Typischerweise ist die erste und zweite erfindungsgemäße Menge von Rechenvorrichtungen in ein Rechenzentrum integriert.

Das beschriebene Verfahren bzw. System zum Kühlen von Rechenvorrichtungen kann besonders effektiv in einem Rechenzentrum angewendet werden, da es hier eine große Anzahl von Rechenvorrichtungen mit definierten Temperaturerfordernissen gibt, die entsprechend der ersten, zweiten oder einer anderen Menge zugewiesen werden können.

Vorzugsweise ist die zweite Menge von Rechenvorrichtungen in einer Warmgangeinhausung der ersten Menge von Rechenvorrichtungen angeordnet.

Wie oben bereits erläutert, bezeichnet der Warmgang den Raum, in den die warme Abluft der Rechenvorrichtungen in einem Rechenzentrum abgegeben wird. Die Warmgangeinhausung entspricht der Einhüllung dieses Raums. Die zweite Menge von Rechenvorrichtungen kann in diesem Warmgang oder in dieser Warmgangeinhausung angeordnet werden, da die zweite Menge von Rechenvorrichtungen durch die von der ersten Menge von Rechenvorrichtungen abgegebenen Abluft gekühlt wird.

Vorzugsweise umfasst die Kühlluftquelle einen Wärmetauscher.

Das Kühlsystem kann als eine indirekte freie Kühlung mit Wärmetauscher ausgestaltet sein, wodurch die Wirkung und Energieeinsparung bei dem erfindungsgemäßen Verfahren bzw. System bei konstanter Luftqualität verbessert wird.

Zusätzlich kann bei Bedarf Luft mit der ersten Temperatur über eine Umgehung (Bypass) der ersten Menge von Rechenvorrichtungen in den Raum mit der Luft mit der zweiten Temperatur gelangen. Bevorzugt weist die Umgehung eine Regelung des Umgehungsluftstroms auf, welche etwa ein Regelventil umfasst.

Eine solche Leitung von Luft aus einem Raum mit Luft mit der ersten Temperatur, welcher sich also vor der ersten Menge von Servern befindet, über eine Umgehung zu einem Raum mit Luft mit der zweiten Temperatur ermöglicht es, einen Unterdruck in dem Raum mit Luft mit der zweiten Temperatur auszugleichen. Ein solcher Unterdruck in dem Raum mit Luft mit der zweiten Temperatur kann beispielsweise entstehen, wenn die Ventilatoren der ersten Menge von Rechenvorrichtungen mit einer geringeren Leistung als die Ventilatoren der zweiten Menge von Rechenvorrichtungen arbeiten. In diesem Fall wird mehr Luft aus dem Raum mit Luft mit der zweiten Temperatur abgesaugt, als von der ersten Menge von Rechenvorrichtungen eingegeben wird. Die Umgehung ermöglicht es, den Unterdruck zu verringern oder zu verhindern. Weist die Umgehung zusätzlich eine Regelung auf, etwa mit einem Regelventil, kann die Luftzufuhr mit Luft mit der ersten Temperatur je nach Bedarf gesteuert werden. Diese Umgehung kann nicht nur zum Druckausgleich verwendet werden, sondern auch dazu, die Temperatur in dem Raum mit der zweiten Temperatur durch Zufuhr von Luft mit der ersten Temperatur zu senken.

Eine entsprechende Umgehung kann auch zwischen dem Raum mit der Luft mit der zweiten Temperatur und dem Raum hinter der zweiten Menge von Rechenvorrichtungen (beispielsweise einem Raum mit Luft mit einer dritten Temperatur) vorgesehen sein, um einen Überdruck in dem Raum mit der Luft mit der zweiten Temperatur zu verringern oder zu verhindern.

Vorzugsweise ist die Temperatur der Luft mit der ersten Temperatur mindestens 1 °C, bevorzugt mindestens 2 °C, weiter bevorzugt mindestens 4 °C, weiter bevorzugt mindestens 6 °C und am meisten bevorzugt mindestens 10 °C geringer, als die Temperatur der Luft mit der zweiten Temperatur.

Der Temperaturunterschied entsteht durch die entsprechende Abgabe von Wärmeenergie von mindestens einer Rechenvorrichtung aus der ersten Menge von Rechenvorrichtungen.

Vorzugsweise ist der Raum mit der Luft mit der zweiten Temperatur so umbaut, dass Luft durch einen oder mehrere definierte Lufteinlässe in diesen eindringt und diesen durch einen oder mehrere definierte Luftauslässe verlässt.

Eine Umbauung des Raums durch beispielsweise Einrichtungsgegenstände oder sonstige Strukturen ermöglicht es einen mit einem definierten Lufteinlass und Luftauslass ausgestatteten Raum zu schaffen, der eine bestimmte Temperatur aufweisen kann. Dieser Raum soll im so abgedichtet sein, dass die Luft größtenteils durch die definierten Ein- und Auslässe ein- und ausdringt. Vorzugsweise dringen mindestens 60 %, bevorzugt mindestens 70 %, weiter bevorzugt mindestens 80 % und am meisten bevorzugt mindestens 90 % der sich im Raum befindenden Luft durch die definierten Ein- und Auslässe während des Betriebs des Systems bzw. der Durchführung des Verfahrens ein und aus.

Vorzugsweise wird der definierte Lufteinlass durch mindestens eine Rechenvorrichtung aus der ersten Menge von Rechenvorrichtungen und/oder der definierte Luftauslass durch mindestens eine Rechenvorrichtung aus der zweiten Menge von Rechenvorrichtungen definiert.

### Kurze Beschreibung der Zeichnungen

Weitere Beispiele und Ausführungsformen werden im Folgenden anhand der Zeichnungen beschrieben, bei der:
Fig. 1 eine schematische Darstellung des im Stand der Technik verwendeten Kühlverfahrens zeigt,
Fig. 2 eine schematische Darstellung eines erfindungsgemäßen Kühlverfahrens zeigt,
Fig. 3 eine Seitenansicht einer vertikalen Anordnung von Rechenvorrichtungen entsprechend einer Ausführungsform der Erfindung veranschaulicht,
Fig. 4 eine Seitenansicht einer horizontalen Anordnung von Rechenvorrichtungen entsprechend einer weiteren Ausführungsform der Erfindung veranschaulicht.

### Detaillierte Beschreibung bevorzugter Ausführungsbeispiele

**Fig. 2** zeigt eine schematische Darstellung des erfindungsgemäßen Kühlverfahrens bzw. -systems. Ein solches System weist eine erste Menge von Rechenvorrichtungen 1 und eine zweiten Menge von Rechenvorrichtungen 2 sowie eine Kühlluftquelle 3 auf.

Die erste und/oder die zweite Menge von Rechenvorrichtungen kann aus einer einzigen oder mehreren Rechenvorrichtungen bestehen. Unter dem Begriff Rechenvorrichtung, ist hier jede Rechenvorrichtung zu verstehen, die in einem Rechenzentrum angeordnet sein kann und auf welcher Software ausgeführt werden kann. Insbesondere aber nicht ausschließlich kann eine Rechenvorrichtung eines der folgenden sein: ein Server, ein Router, ein Switch, eine Speichervorrichtung, eine Netzwerkkomponente und jedes andere IT-Gerät, das in einem Rechenzentrum verwendet wird, und typischerweise einen eigenen regelbaren Ventilator aufweist.

Die erste Menge von Rechenvorrichtungen 1 kann mindestens eine Rechenvorrichtung enthalten, die eine Kühlung mit Luft mit geringerer Temperatur als die Rechenvorrichtungen aus der zweiten Menge von Rechenvorrichtungen 2 erfordert. Im Detail kann die erste Menge von Rechenvorrichtungen 1 mindestens eine Rechenvorrichtung enthalten, die mindestens eine Komponente beinhaltet, die eine Kühlung mit Luft mit geringerer Temperatur als die Komponenten der Rechenvorrichtungen der zweiten Menge von Rechenvorrichtungen 2 erfordert. Die erforderliche Temperatur der Kühlluft der zweiten Menge von Rechenvorrichtungen 2 kann beispielsweise ungefähr zwischen 5 und 20 K höher sein als die der ersten Menge von Rechenvorrichtungen 1.

Obwohl in der Fig. 2 nur zwei Mengen von Rechenvorrichtungen 1, 2 abgebildet sind, wird der Fachmann verstehen, dass das vorgestellte Verfahren bzw. System auch für mehr als zwei Mengen (Stufen) von Rechenvorrichtungen verwendet werden kann. Beispielsweise kann das Verfahren bzw. System zur Kühlung von drei oder mehr hintereinander angeordneten Mengen von Rechenvorrichtungen verwendet werden.

Die Kühlluftquelle 3 gibt Luft mit einer ersten Temperatur 10 aus. Diese Temperatur kann beispielsweise bei derzeitigem Stand der Technik bei aktuellen Rechenzentren in einem Bereich von 18 bis 27 °C liegen.

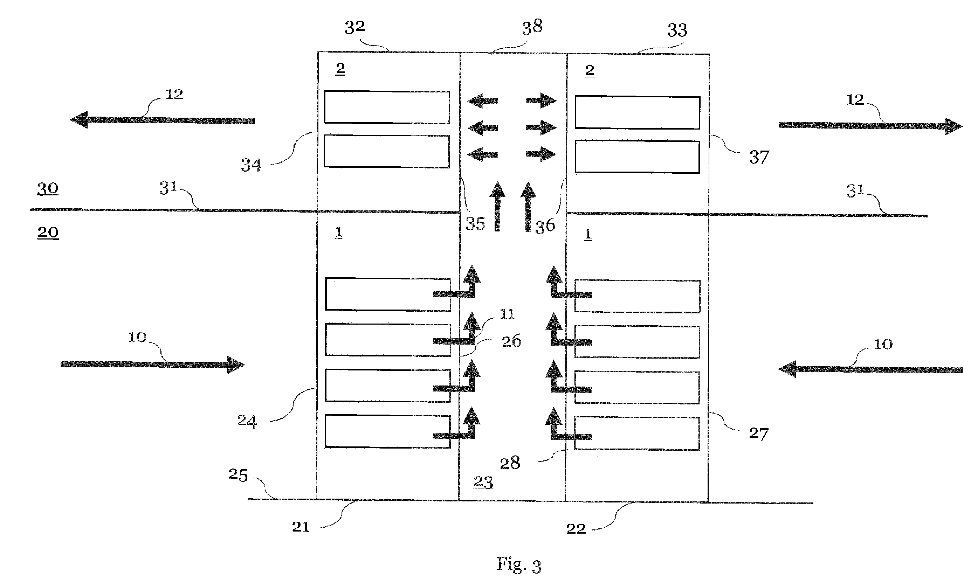

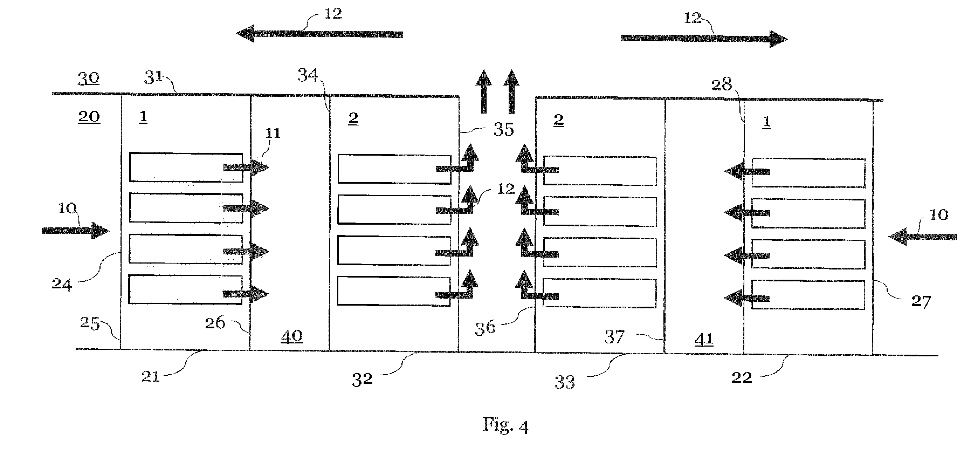

Die Kühlluftquelle 3 kann jede Art von Kühlvorrichtung sein. Die Kühlluftquelle 3 kann als eine passive oder aktive Kühlvorrichtung ausgestaltet sein. Zum Beispiel kann die Kühlluftquelle 3 einen Wärmetauscher umfassen, welcher eine durch die Kühlung der Rechenvorrichtung erhitzte Luft mithilfe der Außentemperatur kühlt. Weiterhin kann eine solche passive Kühlvorrichtung durch eine aktive Kühlvorrichtung unterstützt werden. Eine solche Kombination kann einen durchgehenden von der Außentemperatur unabhängigen Betrieb gewährleisten. Die Kühlluftquelle 3 kann sich auch aus mehreren Kühlluftquellen zusammensetzen, welche unterschiedliche Kühlkreisläufe bilden und sich auch überlappen können. Auch können mehrere Kühlluftquellen eingerichtet sein, um einen Raum mit einer konstanten Temperatur durch redundante Auslegung bereitzustellen. Die Einbeziehung von mehreren Kühlluftquellen wird in den Figuren 3 und 4 angedeutet.

Die von der Kühlluftquelle 3 ausgegebene Luft mit der ersten Temperatur 10 wird ganz oder teilweise zu der ersten Menge von Rechenvorrichtungen 1 geleitet, um diese zu kühlen. Die Bewegung des Luftstroms von der Kühlluftquelle 3 zu der ersten Menge von Rechenvorrichtungen 1 kann beispielsweise durch ein Ausstoßen von der Kühlluftquelle 3 und/oder ein Ansaugen von der ersten Menge von Rechenvorrichtungen 1, beispielsweise mithilfe von Ventilatoren, verursacht werden.

Mindestens ein Teil der zu der ersten Menge von Rechenvorrichtungen 1 geleiteten Luft mit der ersten Temperatur 10 wird in die erste Menge von Rechenvorrichtungen 1 eingegeben. Die erste Menge von Rechenvorrichtungen 1 wird durch die Luft mit der ersten Temperatur 10 gekühlt.

Eine solche Kühlung umfasst einen Wärmetausch in der einen oder den mehreren Rechenvorrichtungen aus der ersten Menge von Rechenvorrichtungen 1. Dabei wird Wärme von den Komponenten der einen oder mehreren Rechenvorrichtungen aus der ersten Menge von Rechenvorrichtungen 1 an die Luft mit der ersten Temperatur 10 abgegeben, wodurch sich diese aufheizt.

Die Temperatur der Luft wurde beim Kühlen der ersten Menge von Rechenvorrichtungen 1 erhöht. Diese erhöhte Temperatur kann beispielsweise bei derzeitigem Stand der Technik in einem Bereich von 18 bis 50 °C liegen. Die Temperatur der Luft im Raum hinter der ersten Menge von Rechenvorrichtungen zweite Temperatur muss dabei nicht der Temperatur der Abwärme einer einzelnen Rechenvorrichtung aus der Menge von ersten Rechenvorrichtungen entsprechen, sondern kann sich auch aus einer Mischung der Abwärmen aller Rechenvorrichtung aus der ersten Menge von Rechenvorrichtungen oder einer Mischung mit einem anderen Luftstrom ergeben. Folglich hat die Luft 11 in dem Raum hinter der ersten Menge von Rechenvorrichtungen eine zweite Temperatur, die höher als die erste Temperatur der Luft ist, welche von der Kühlluftquelle ausgegeben wird.

Diese Luft mit der zweiten Temperatur 11 wird ganz oder teilweise zu der zweiten Menge von Rechenvorrichtungen 2 geleitet. Diese Weiterleitung kann sowohl von der ersten Menge von Rechenvorrichtungen 1 als auch der zweiten Menge von Rechenvorrichtungen 2 durch Ausgeben oder Ansaugen unterstützt werden.

Die Luft mit der zweiten Temperatur 11 wird nachfolgend in die zweite Menge von Rechenvorrichtungen 2 eingegeben. Die zweite Menge von Rechenvorrichtungen 2 wird durch die Luft mit der zweiten Temperatur 11 gekühlt, und die dadurch erzeugte Abwärme wird aus der zweiten Menge von Rechenvorrichtungen 2 ausgegeben. Der Ablauf der Kühlung ist analog zu der Kühlung der ersten Menge von Rechenvorrichtungen 1, wobei die Komponenten der einen oder der mehreren Rechenvorrichtungen aus der zweiten Menge von Rechenvorrichtungen 2 Wärme abgeben. Die Temperatur der ausgegebenen Luft wurde durch die Kühlung der zweiten Menge von Rechenvorrichtungen 2 erhöht. Diese erhöhte Temperatur kann beispielsweise bei derzeitigem Stand der Technik in einem Bereich von 18 bis 65°C liegen.

Somit wurde die zweite Menge von Rechenvorrichtungen 2 mit der Abluft der ersten Menge von Rechenvorrichtungen 1 gekühlt, und die Temperatur der von der zweiten Menge von Rechenvorrichtungen ausgegebenen Luft wurde weiter erhöht.

In einem nächsten Schritt kann die von der zweiten Menge von Rechenvorrichtungen ausgegebene Luft 12 ganz oder teilweise zurück an die Kühlluftquelle 3 geleitet werden, um den Kühlkreislauf zu schließen. Dies ist beispielsweise der Fall bei einer indirekten freien Kühlung, bei der beispielsweise ein Wärmetauscher als Kühlluftquelle 3 verwendet wird. In einem solchen Fall kann durch die Erfindung der Wirkungsgrad des Wärmetauschers erhöht werden, da der Temperaturunterschied zwischen der Außentemperatur oder der Temperatur einer Wasserquelle und der beim Kühlen der Rechenvorrichtungen erwärmten Luft größer ist als in konventionellen Systemen, in denen die Abluft nicht durch eine zweite Menge von Rechenvorrichtungen 2 weiter aufgeheizt wird.

Alternativ dazu, in dem Fall, in dem die Kühlluftquelle 3 als direkte freie Kühlung ausgestaltet ist, kann die von der zweiten Menge von Rechenvorrichtungen ausgegebene Luft ganz oder teilweise in die Außenluft abgegeben werden. In einem solchen Fall wird die von der zweiten Menge von Rechenvorrichtungen ausgegebene Luft nicht zurück an die Kühlluftquelle 3 geleitet. Im Falle der direkten Kühlung kühlt die Kühlluftquelle 3 die von den Rechenvorrichtungen erhitzte Luft nicht, sondern sie bezieht Außenluft, kühlt diese ggf. noch herunter, und gibt diese an die erste Menge von Rechenvorrichtungen aus. In einem solchen Fall bietet das erfindungsgemäße System bzw. Verfahren jedoch immer noch den Vorteil, dass weniger Luft bewegt und auf die geringere Temperatur, welche von den Rechenvorrichtungen aus der ersten Menge von Rechenvorrichtungen 1 gefordert wird, gekühlt werden muss.

Im Folgenden werden bevorzugte Ausführungsbeispiele von Anordnungen von Rechenvorrichtungen gemäß der Erfindung im Detail beschrieben.

**Fig. 3** zeigt eine Seitenansicht einer vertikalen Anordnung von Rechenvorrichtungen entsprechend einer Ausführungsform der Erfindung. Eine solche Anordnung von Rechenvorrichtungen kann beispielsweise in einem Rechenzentrum eingerichtet werden. Die erste Menge von Rechenvorrichtungen 1 und/oder die zweite Menge von Rechenvorrichtungen 2 können in einem oder mehreren Serverschränken angeordnet sein. In der Regel sind solche Serverschränke in Rechenzentren in Reihen angeordnet, wobei die Reihen jeweils in Gruppen von zwei Reihen aufgeteilt sind, in denen die Serverschränke so angeordnet sind, dass die Rückseiten der Serverschränke sich gegenüberstehen. Unter Serverschrank ist jede Art von Schrank, Rack und Regal zu verstehen, welche in der Lage sind eine oder mehrere Rechenvorrichtungen aufzunehmen. Vorzugsweise ist ein solcher Serverschrank so abgedichtet, dass Luft nur durch einen definierten Lufteinlass hineinströmen und nur durch einen definierten Luftauslass herausströmen kann. In der Regel weisen die Serverschränke aber immer auch Leckagen auf.

Jede Rechenvorrichtung kann ein Gehäuse aufweisen, wobei das Gehäuse einen Lufteinlass und eine Luftauslass aufweisen kann. Zudem kann jede Rechenvorrichtung einen Ventilator beinhalten, der durch die Rechenvorrichtungen selbst regelbar ist. Damit kann die Rechenvorrichtung den Luftfluss durch das Gehäuse je nach Bedarf steuern. Demnach kann die Rechenvorrichtungen den Ventilator mit einer ersten Geschwindigkeit antreiben, wenn die Temperatur der Rechenvorrichtung einen bestimmten Schwellenwert überschreitet, und den Ventilator mit einer zweiten Geschwindigkeit antreiben, wenn die Temperatur der Rechenvorrichtung unter dem bestimmten Schwellenwert liegt, wobei die erste Geschwindigkeit höher als die zweite Geschwindigkeit ist.

In der vorliegenden Ausführungsform beinhaltet ein erster Serverschrank 21 und ein zweiter Serverschrank 22 die erste Menge von Rechenvorrichtungen 1, wobei sowohl der erste Serverschrank 21 als auch der zweite Serverschrank 22 in einer Reihe von Serverschränken angeordnet werden können. Die zweite Menge von Rechenvorrichtungen 2 ist in einem dritten Serverschrank 32 und einem vierten Serverschrank 33 angeordnet, welche oberhalb der Serverschränke 21, 22, welche die erste Menge von Rechenvorrichtungen 1 beinhalten, platziert sind. Die ersten und zweiten Serverschränke 21, 22 sind auf einem Boden 25 platziert. Die dritten und vierten Serverschränke 32, 33 sind jeweils über dem ersten und zweiten Serverschrank 21, 22 platziert. Die Ausrichtung der ersten und zweiten Serverschränke 21, 22 ist dabei entgegengesetzt zu der Ausrichtung der dritten und vierten Serverschränke 32, 33. Im Detail, stehen die ersten und zweiten Serverschränke 21, 22 sich mit ihren Luftauslässen und die dritten und vierten Serverschränke 32, 33 sich mit ihren Lufteinlässen entgegen.

Nachfolgend wird der Kühlungsablauf bei einem solchen Serveraufbau im Detail erläutert.

Die von der Kühlluftquelle 3 stammende Luft mit der ersten Temperatur 10 kann in die erste Menge von Rechenvorrichtungen 1 eingegeben werden, indem sie durch den Lufteinlass 24 des ersten Serverschranks 21 und/oder durch den Lufteinlass 27 des zweiten Serverschranks 22 eindringt. In der gezeigten Ausgangsform dringt die Luft mit der ersten Temperatur 10 von einem Raum mit Luft mit der ersten Temperatur 20 durch die Vorderseiten der Serverschränke ein. Die Lufteinlässe können jedoch je nach Aufbau an einer anderen Seite des Serverschranks platziert sein. Beispielsweise können die Lufteinlässe an den Unterseiten der Serverschränke angeordnet sein. In einem solchen Fall ist das Rechenzentrum in der Regel mit einem doppelten Boden ausgerüstet, so dass die von der Kühlluftquelle 3 stammende Luft durch einen Kaltgang in dem doppelten Boden zu den Serverschränken gelangen kann. Unter Kaltgang versteht man in einem Rechenzentrum einen Raum, in dem sich die kalte Luft befindet, die den Rechenvorrichtungen zur Kühlung bereitgestellt wird.

Die Temperatur der Luft in dem Raum mit Luft der ersten Temperatur 20 kann durch mehrere redundante Kühlluftquellen 3 konstant gehalten werden, um einen sicheren Betrieb zu gewährleisten. Durch eine solche redundante Auslegung kann sichergestellt werden, dass die Luft in dem Raum 20 immer die erste Temperatur aufweist.

Auch können mehrere Kühlluftquellen 3 so eingerichtet sein, dass die Luft einer ersten Kühlluftquelle durch den Lufteinlass 24 des ersten Serverschrank 21 eindringen kann und die Luft einer zweiten Kühlluftquelle durch den Lufteinlass 27 des zweiten Serverschrank 22 eindringen kann. Die Luft der ersten Kühlluftquelle und der zweiten Kühlluftquelle können beide die erste Temperatur aufweisen oder sie können von unterschiedlicher Temperatur sein.

Anschließend kann die Luft mit der ersten Temperatur 10 die erste Menge von Rechenvorrichtungen 1 kühlen, indem sie die eine oder die mehreren Rechenvorrichtungen aus der ersten Menge von Rechenvorrichtungen 1 in dem ersten Serverschrank 21 und/oder in dem zweiten Serverschrank 22 passiert und Komponenten der einen oder der mehreren Rechenvorrichtungen Wärme an sie abgeben. Die erhitzte Luft verlässt die Rechenvorrichtung und die Serverschränke 21, 22 über den Luftauslass 26 und/oder über den Luftauslass 28 und kommt in einen Raum 23. Die Luftauslässe 26, 28 sind in der vorliegenden Ausführungsform an den Rückseiten der Serverschränke 21, 22 angeordnet. Es wird für den Fachmann jedoch klar sein, dass die Luftauslässe auch an einer anderen Seite der Serverschränke angeordnet sein können, wie beispielsweise an der Oberseite der Serverschränke.

Die Temperatur der Luft in dem Raum 23 entspricht einer zweiten Temperatur 11, welche nicht in dem gesamten Raum 23 gleich sein muss. Die Temperatur der Luft im Raum 23 kann sich aus mehreren Komponenten zusammensetzen, beispielsweise der ausgegebenen Luft von einer oder mehreren Rechenvorrichtungen aus der ersten Menge von Rechenvorrichtungen 1 aus dem Serverschrank 21 und/oder aus dem Serverschrank 22 oder anderen zusätzlichen Luftströmen.

Falls die individuellen Ventilatoren der Rechenvorrichtungen aus der zweiten Menge von Rechenvorrichtungen 2 mehr Luft ansaugen als die Ventilatoren der Rechenvorrichtungen aus der ersten Menge von Rechenvorrichtungen 1, kann ein Unterdruck in dem Raum 23 entstehen, welcher durch eine Umgehung, auch Bypass genannt, aufgehoben oder vermindert werden kann. Eine solche Umgehung kann mit einem Regelventil ausgestattet sein, um die Umgehung je nach Bedarf entsprechend zu regeln. Eine solche Umgehung könnte in dieser Ausführungsform als ein Luftdurchlass zwischen dem Raum mit der ersten Temperatur 20 und dem Raum mit der zweiten Temperatur 23 ausgestaltet sein.

Der Raum mit Luft der zweiten Temperatur 23 entspricht einem Raum, der zwischen zwei Serverschränken oder -reihen gebildet sein kann. Der Raum bildet einen Teil einer Warmgangeinhausung. In diesem Aufbau sind die Rückseiten der Serverschränke 21, 22, 32, 33 dem Raum mit Luft der zweiten Temperatur 23 zugewendet. Weiterhin wird dieser Raum 23 durch eine Decke 38 und den Boden 25 in vertikaler Richtung begrenzt.

Die Luft in dem Raum mit Luft mit der zweiten Temperatur 23 wird zum Kühlen der zweiten Menge von Rechenvorrichtungen 2 verwendet, welche oberhalb der ersten Menge von Rechenvorrichtungen 1 in den Serverschränken 32, 33 angeordnet sind. Sie wird typischerweise von der ersten Menge von Rechenvorrichtungen 1 durch Ventilatoren in den Raum hineingeblasen und von der zweiten Menge von Rechenvorrichtungen 2 aus dem Raum abgesaugt. Wie oben bereits erwähnt kann es bei einem unterschiedlichen Bedarf an Kühlluft der ersten Menge von Rechenvorrichtung 1 und der zweiten Menge von Rechenvorrichtungen 2 gegebenenfalls zu einem Unterdruck in dem Raum mit Luft der zweiten Temperatur 23 kommen. Ein solcher Unterdruck kann wie auch oben beschrieben mithilfe einer regelbaren Umgehung verringert oder verhindert werden.

Damit die Luft mit der ersten Temperatur 10 nicht zu den Luftauslässen 34, 37 der Serverschränke 32, 33 gelangen kann, welche die zweite Menge von Rechenvorrichtungen 2 beinhalten, kann ein Raum 20 mit Luft mit der ersten Temperatur 10 auf einer ersten Ebene, auf welcher sich die Serverschränke 21, 22 befinden durch eine Trennung 31 von einem Raum 30 mit Luft einer dritten Temperatur 12 auf einer zweiten Ebene, auf welcher die Serverschränke 32, 33 angeordnet sind, getrennt werden.

Die zweite Menge von Rechenvorrichtungen 2, in den dritten und vierten Serverschränken 32, 33 wird durch die Luft mit der zweiten Temperatur 11 aus dem Raum 23 gekühlt, indem diese Luft über die Lufteinlässe 35, 36 der dritten und vierten Serverschränke 32, 33 und die entsprechenden Rechenvorrichtungen eindringt. Die Lufteinlässe 35, 36 sind in der vorliegenden Ausführungsform an der Rückseite der Serverschränke 32, 33 angeordnet. Diese können jedoch je nach Aufbau der Serverschränke an einer anderen Seite angeordnet sein.

Anschließend geben Komponenten der einen oder der mehreren Rechenvorrichtungen der zweiten Menge von Rechenvorrichtungen 2 ihre Wärme an die eindringende Luft mit der zweiten Temperatur 11 ab, welche den dritten und vierten Serverschrank 32, 33 über die Luftauslässe 34, 37 verlässt. Die Luftauslässe 34, 37 sind in dieser Ausführungsform an der Vorderseite der Serverschränke angeordnet. Diese Anordnung kann jedoch je nach Serveraufbau variieren. So können beispielsweise die Luftauslässe auch an den Oberseiten der Serverschränke angeordnet sein.

Die von der zweiten Menge von Rechenvorrichtungen ausgegebene Luft 12 kann, wie bereits oben beschrieben bei einer indirekten freien Kühlung ganz oder teilweise zurück an die Kühlluftquelle 3 geleitet werden, um den Kühlkreislauf zu schließen. Alternativ kann bei einer direkten freien Kühlung die von der zweiten Menge von Rechenvorrichtungen 2 ausgegebene Luft 12 ganz oder teilweise in die Außenluft ausgestoßen werden.

Die vertikale Anordnung der Rechenvorrichtungen bietet den Vorteil, dass die zweite Menge von Rechenvorrichtungen 2 in eine Warmgangeinhausung integriert werden kann. Auch bietet eine solche Anordnung den Vorteil, dass die Fläche des Rechenzentrums möglichst effizient genutzt werden kann.

**Fig. 4** zeigt eine Seitenansicht einer horizontalen Anordnung von Rechenvorrichtungen entsprechend einer weiteren Ausführungsform der Erfindung. Diese Ausführungsform folgt dem gleichen Prinzip wie die mit Bezug auf Fig. 3 beschriebene mit dem Unterschied, dass der dritte und vierte Serverschrank 32, 33 nicht oberhalb des ersten und zweiten Serverschranks 21, 22 angeordnet sind, sondern sich zwischen dem ersten und dem zweiten Serverschrank 21, 22 befinden. Demnach entstehen hier zwei unterschiedliche Räume 40, 41, zwischen dem ersten Serverschrank 21 und dem dritten Serverschrank 32 sowie zwischen dem zweiten Serverschrank 22 und dem vierten Serverschrank 33.

### Bezugszeichenliste

- 1: Erste Menge von Rechenvorrichtungen
- 2: Zweite Menge von Rechenvorrichtungen
- 3: Kühlluftquelle
- 10: Luftstrom mit der ersten Temperatur
- 11: Luftstrom mit der zweiten Temperatur
- 12: Luftstrom mit der dritten Temperatur
- 20: Raum mit Luft der ersten Temperatur
- 21: Erster Serverschrank
- 22: Zweiter Serverschrank
- 23: Raum mit Luft der zweiten Temperatur
- 24: Lufteinlass des ersten Serverschranks
- 25: Boden
- 26: Luftauslass des ersten Serverschranks
- 27: Lufteinlass des zweiten Serverschranks
- 28: Luftauslass des zweiten Serverschranks
- 30: Raum mit Luft der dritten Temperatur
- 31: Trennung
- 32: Dritter Serverschrank
- 33: Vierter Serverschrank
- 34: Luftauslass des dritten Serverschranks
- 35: Lufteinlass des dritten Serverschranks
- 36: Lufteinlass des vierten Serverschranks
- 37: Luftauslass des vierten Serverschranks
- 38: Decke
- 40: Erster Raum mit Luft der zweiten Temperatur
- 41: Zweiter Raum mit Luft der zweiten Temperatur

## Patentansprüche

1. System zum Kühlen von Rechenvorrichtungen, welches dazu eingerichtet ist, einen Luftstrom zwischen einer Kühlluftquelle, einer ersten Menge von Rechenvorrichtungen und einer zweiten Menge von Rechenvorrichtungen zu erzeugen, und dabei
durch die Kühlluftquelle Luft mit einer ersten Temperatur auszugeben;
die erste Menge von Rechenvorrichtungen mit durch die Kühlluftquelle ausgegebener Luft zu kühlen, wobei mindestens ein Teil der durch die Kühlluftquelle ausgegebenen Luft in die erste Menge von Rechenvorrichtungen eingegeben wird und von der ersten Menge von Rechenvorrichtungen aufgeheizt und in einen Raum mit Luft mit einer zweiten Temperatur ausgegeben wird, welche höher als die erste Temperatur ist; und
die zweite Menge von Rechenvorrichtungen mit Luft aus dem Raum mit der Luft mit der zweiten Temperatur zu kühlen, wobei mindestens ein Teil der Luft aus dem Raum mit der Luft mit der zweiten Temperatur in die zweite Menge von Rechenvorrichtungen eingegeben und von der zweiten Menge von Rechenvorrichtungen aufgeheizt und ausgegeben wird.

2. System zum Kühlen von Rechenvorrichtungen nach Anspruch 1, wobei das System eine dritte Menge von Rechenvorrichtungen umfasst,
wobei mindestens ein Teil der von der zweiten Menge von Rechenvorrichtungen aufgeheizten Luft in einen Raum mit Luft mit einer dritten Temperatur ausgegeben wird, welche höher als die zweite Temperatur ist; und
das System dazu eingerichtet ist, die dritte Menge von Rechenvorrichtungen mit Luft aus dem Raum mit der Luft mit der dritten Temperatur zu kühlen, wobei mindestens ein Teil der Luft aus dem Raum mit der Luft mit der dritten Temperatur in die dritte Menge von Rechenvorrichtungen eingegeben und von der dritten Menge von Rechenvorrichtungen aufgeheizt und ausgegeben wird.

3. System zum Kühlen von Rechenvorrichtungen nach irgendeinem der vorhergehenden Ansprüche, wobei das System dazu eingerichtet ist, mindestens einen Teil der von der zweiten und/oder, wenn das System ein System nach Anspruch 2 ist, von der dritten Menge von Rechenvorrichtungen aufgeheizten und ausgegebenen Luft zurück zur Kühlluftquelle zu leiten und wobei mindestens ein Teil der zurück zur Kühlluftquelle geleiteten Luft durch die Kühlluftquelle gekühlt wird.

4. Verfahren zum Kühlen von Rechenvorrichtungen, umfassend:
Ausgeben von Luft mit einer ersten Temperatur durch eine Kühlluftquelle;
Kühlen einer ersten Menge von Rechenvorrichtungen mit durch die Kühlluftquelle ausgegebener Luft, wobei mindestens ein Teil der durch die Kühlluftquelle ausgegebenen Luft in die erste Menge von Rechenvorrichtungen eingegeben wird und von der ersten Menge von Rechenvorrichtungen aufgeheizt und in einen Raum mit Luft mit einer zweiten Temperatur ausgegeben wird, welche höher als die erste Temperatur ist; und
Kühlen einer zweiten Menge von Rechenvorrichtungen mit Luft aus dem Raum mit der Luft mit der zweiten Temperatur, wobei mindestens ein Teil der Luft aus dem Raum mit der Luft mit der zweiten Temperatur in die zweite Menge von Rechenvorrichtungen eingegeben und von der zweiten Menge von Rechenvorrichtungen aufgeheizt und ausgegeben wird.

5. System beziehungsweise Verfahren zum Kühlen von Rechenvorrichtungen nach irgendeinem der vorhergehenden Ansprüche, wobei mindestens eine der Rechenvorrichtungen aus der ersten Menge von Rechenvorrichtungen eine Kühlung mit Luft mit geringerer Temperatur als mindestens eine der Rechenvorrichtungen aus der zweiten Menge von Rechenvorrichtungen erfordert und/oder, wenn das System ein System nach Anspruch 2 ist, mindestens eine der Rechenvorrichtungen aus der zweiten Menge von Rechenvorrichtungen eine Kühlung mit Luft mit geringerer Temperatur als mindestens eine der Rechenvorrichtungen aus der dritten Menge von Rechenvorrichtungen erfordert.

6. System beziehungsweise Verfahren zum Kühlen von Rechenvorrichtungen nach irgendeinem der vorhergehenden Ansprüche, wobei eine, mehrere, oder bevorzugt alle Rechenvorrichtungen aus der ersten und/oder zweiten und/oder, wenn das System ein System nach Anspruch 2 ist, der dritten Menge von Rechenvorrichtungen jeweils in einem eigenen Gehäuse angeordnet ist/sind.

7. System beziehungsweise Verfahren zum Kühlen von Rechenvorrichtungen nach Anspruch 6, wobei das Gehäuse jeweils einen Lufteinlass und einen Luftauslass aufweist.

8. System beziehungsweise Verfahren zum Kühlen von Rechenvorrichtungen nach irgendeinem der vorhergehenden Ansprüche, wobei eine, mehrere, oder bevorzugt alle Rechenvorrichtungen aus der ersten und/oder zweiten und/oder, wenn das System ein System nach Anspruch 2 ist, der dritten Menge von Rechenvorrichtungen jeweils einen eigenen Ventilator aufweist/aufweisen.

9. System beziehungsweise Verfahren zum Kühlen von Rechenvorrichtungen nach Anspruch 8, wobei der Ventilator durch die entsprechende Rechenvorrichtung selbst geregelt wird.

10. System beziehungsweise Verfahren zum Kühlen von Rechenvorrichtungen nach irgendeinem der vorhergehenden Ansprüche, wobei die zweite Menge von Rechenvorrichtungen oberhalb der ersten Menge von Rechenvorrichtungen angeordnet ist und/oder, wenn das System ein System nach Anspruch 2 ist, die dritte Menge von Rechenvorrichtungen oberhalb der zweiten Menge von Rechenvorrichtungen angeordnet ist.

11. System beziehungsweise Verfahren zum Kühlen von Rechenvorrichtungen nach irgendeinem der vorhergehenden Ansprüche, wobei die Kühlluftquelle einen Wärmetauscher umfasst.

12. System beziehungsweise Verfahren zum Kühlen von Rechenvorrichtungen nach irgendeinem der vorhergehenden Ansprüche, wobei Luft mit der ersten Temperatur über eine erste Umgehung in den Raum mit der Luft mit der zweiten Temperatur gelangen kann und/oder Luft aus dem Raum mit der Luft mit der zweiten Temperatur über eine zweite Umgehung hinter die zweite Menge von Rechenvorrichtungen gelangen kann und/oder, wenn das System ein System nach Anspruch 2 ist, Luft mit der zweiten Temperatur über eine dritte Umgehung in den Raum mit der Luft mit der dritten Temperatur gelangen kann und/oder Luft aus dem Raum mit der Luft mit der dritten Temperatur über eine vierte Umgehung hinter die dritte Menge von Rechenvorrichtungen gelangen kann.

13. System beziehungsweise Verfahren zum Kühlen von Rechenvorrichtungen nach irgendeinem der vorhergehenden Ansprüche, wobei die erste und/oder zweite, und/oder, wenn das System ein System nach Anspruch 2 ist, die dritte und/oder vierte Umgehung ein Regelventil aufweisen.

14. System beziehungsweise Verfahren zum Kühlen von Rechenvorrichtungen nach irgendeinem der vorhergehenden Ansprüche, wobei die Temperatur der Luft mit der ersten Temperatur mindestens 1 °C, bevorzugt mindestens 2 °C, weiter bevorzugt mindestens 4 °C, weiter bevorzugt mindestens 6 °C und am meisten bevorzugt mindestens 10 °C geringer ist, als die Temperatur der Luft mit der zweiten Temperatur und/oder, wenn das System ein System nach Anspruch 2 ist, die Temperatur der Luft mit der zweiten Temperatur mindestens 1 °C, bevorzugt mindestens 2 °C, weiter bevorzugt mindestens 4 °C, weiter bevorzugt mindestens 6 °C und am meisten bevorzugt mindestens 10 °C geringer ist, als die Temperatur der Luft mit der dritten Temperatur.

15. System beziehungsweise Verfahren zum Kühlen von Rechenvorrichtungen nach irgendeinem der vorhergehenden Ansprüche, wobei der Raum mit der Luft mit der zweiten Temperatur so umbaut ist, dass mindestens 60% der Luft, bevorzugt mindestens 70%, weiter bevorzugt mindestens 80%, am meisten bevorzugt mindestens 90 % die während des Betriebs des Systems bzw. der Durchführung des Verfahrens in den Raum eindringt, durch einen ersten definierten Lufteinlass in diesen eindringt und/oder mindestens 60% der Luft, bevorzugt mindestens 70%, weiter bevorzugt mindestens 80%, die während des Betriebs des Systems bzw. der Durchführung des Verfahrens den Raum verlässt, diesen durch einen ersten definierten Luftauslass verlässt, und/oder, wenn das System ein System nach Anspruch 2 ist, der Raum mit der Luft mit der dritten Temperatur so umbaut ist, dass mindestens 60% der Luft, bevorzugt mindestens 70%, weiter bevorzugt mindestens 80%, am meisten bevorzugt mindestens 90 % die während des Betriebs des Systems in den Raum eindringt, durch einen zweiten definierten Lufteinlass in diesen eindringt und/oder mindestens 60% der Luft, bevorzugt mindestens 70%, weiter bevorzugt mindestens 80%, die während des Betriebs des Systems den Raum verlässt, diesen durch einen zweiten definierten Luftauslass verlässt.

## Geänderte Patentansprüche

### Geänderte Patentansprüche gemäss Regel 137(2) EPÜ.

1. System zum Kühlen von Rechenvorrichtungen, welches dazu eingerichtet ist, einen Luftstrom zwischen einer Kühlluftquelle, einer ersten Menge von Rechenvorrichtungen und einer zweiten Menge von Rechenvorrichtungen zu erzeugen, und dabei
durch die Kühlluftquelle Luft mit einer ersten Temperatur auszugeben;
die erste Menge von Rechenvorrichtungen mit durch die Kühlluftquelle ausgegebener Luft zu kühlen, wobei mindestens ein Teil der durch die Kühlluftquelle ausgegebenen Luft in die erste Menge von Rechenvorrichtungen eingegeben wird und von der ersten Menge von Rechenvorrichtungen aufgeheizt und in einen Raum mit Luft mit einer zweiten Temperatur ausgegeben wird, welche höher als die erste Temperatur ist; und
die zweite Menge von Rechenvorrichtungen mit Luft aus dem Raum mit der Luft mit der zweiten Temperatur zu kühlen, wobei mindestens ein Teil der Luft aus dem Raum mit der Luft mit der zweiten Temperatur in die zweite Menge von Rechenvorrichtungen eingegeben und von der zweiten Menge von Rechenvorrichtungen aufgeheizt und ausgegeben wird,
**dadurch gekennzeichnet, dass**
die zweite Menge von Rechenvorrichtungen oberhalb der ersten Menge von Rechenvorrichtungen angeordnet ist;
die erste Menge von Rechenvorrichtungen von der zweiten Menge von Rechenvorrichtungen durch eine Trennung getrennt ist;
der Luftstrom beim Verlassen der ersten Menge von Rechenvorrichtungen und beim Eindringen in die zweite Menge von Rechenvorrichtungen eine horizontale Flussrichtung aufweist; und
der Luftstrom, in dem Raum mit Luft mit einer zweiten Temperatur, von der ersten Menge von Rechenvorrichtungen zu der zweiten Menge von Rechenvorrichtungen eine vertikale Flussrichtung aufweist.

2. System zum Kühlen von Rechenvorrichtungen nach Anspruch 1, wobei das System eine dritte Menge von Rechenvorrichtungen umfasst,
wobei mindestens ein Teil der von der zweiten Menge von Rechenvorrichtungen aufgeheizten Luft in einen Raum mit Luft mit einer dritten Temperatur ausgegeben wird, welche höher als die zweite Temperatur ist; und
das System dazu eingerichtet ist, die dritte Menge von Rechenvorrichtungen mit Luft aus dem Raum mit der Luft mit der dritten Temperatur zu kühlen, wobei mindestens ein Teil der Luft aus dem Raum mit der Luft mit der dritten Temperatur in die dritte Menge von Rechenvorrichtungen eingegeben und von der dritten Menge von Rechenvorrichtungen aufgeheizt und ausgegeben wird.

3. System zum Kühlen von Rechenvorrichtungen nach irgendeinem der vorhergehenden Ansprüche, wobei das System dazu eingerichtet ist, mindestens einen Teil der von der zweiten und/oder, wenn das System ein System nach Anspruch 2 ist, von der dritten Menge von Rechenvorrichtungen aufgeheizten und ausgegebenen Luft zurück zur Kühlluftquelle zu leiten und wobei mindestens ein Teil der zurück zur Kühlluftquelle geleiteten Luft durch die Kühlluftquelle gekühlt wird.

4. Verfahren zum Kühlen von Rechenvorrichtungen, umfassend:
Ausgeben von Luft mit einer ersten Temperatur durch eine Kühlluftquelle;
Kühlen einer ersten Menge von Rechenvorrichtungen mit durch die Kühlluftquelle ausgegebener Luft, wobei mindestens ein Teil der durch die Kühlluftquelle ausgegebenen Luft in die erste Menge von Rechenvorrichtungen eingegeben wird und von der ersten Menge von Rechenvorrichtungen aufgeheizt und in einen Raum mit Luft mit einer zweiten Temperatur ausgegeben wird, welche höher als die erste Temperatur ist; und
Kühlen einer zweiten Menge von Rechenvorrichtungen mit Luft aus dem Raum mit der Luft mit der zweiten Temperatur, wobei mindestens ein Teil der Luft aus dem Raum mit der Luft mit der zweiten Temperatur in die zweite Menge von Rechenvorrichtungen eingegeben und von der zweiten Menge von Rechenvorrichtungen aufgeheizt und ausgegeben wird,
**dadurch gekennzeichnet, dass**
die zweite Menge von Rechenvorrichtungen oberhalb der ersten Menge von Rechenvorrichtungen angeordnet ist;
die erste Menge von Rechenvorrichtungen von der zweiten Menge von Rechenvorrichtungen durch eine Trennung getrennt ist;
der Luftstrom beim Verlassen der ersten Menge von Rechenvorrichtungen und beim Eindringen in die zweite Menge von Rechenvorrichtungen eine horizontale Flussrichtung aufweist; und
der Luftstrom, in dem Raum mit Luft mit einer zweiten Temperatur, von der ersten Menge von Rechenvorrichtungen zu der zweiten Menge von Rechenvorrichtungen eine vertikale Flussrichtung aufweist.

5. System beziehungsweise Verfahren zum Kühlen von Rechenvorrichtungen nach irgendeinem der vorhergehenden Ansprüche, wobei mindestens eine der Rechenvorrichtungen aus der ersten Menge von Rechenvorrichtungen eine Kühlung mit Luft mit geringerer Temperatur als mindestens eine der Rechenvorrichtungen aus der zweiten Menge von Rechenvorrichtungen erfordert und/oder, wenn das System ein System nach Anspruch 2 ist, mindestens eine der Rechenvorrichtungen aus der zweiten Menge von Rechenvorrichtungen eine Kühlung mit Luft mit geringerer Temperatur als mindestens eine der Rechenvorrichtungen aus der dritten Menge von Rechenvorrichtungen erfordert.

6. System beziehungsweise Verfahren zum Kühlen von Rechenvorrichtungen nach irgendeinem der vorhergehenden Ansprüche, wobei eine, mehrere, oder bevorzugt alle Rechenvorrichtungen aus der ersten und/oder zweiten und/oder, wenn das System ein System nach Anspruch 2 ist, der dritten Menge von Rechenvorrichtungen jeweils in einem eigenen Gehäuse angeordnet ist/sind.

7. System beziehungsweise Verfahren zum Kühlen von Rechenvorrichtungen nach Anspruch 6, wobei das Gehäuse jeweils einen Lufteinlass und einen Luftauslass aufweist.

8. System beziehungsweise Verfahren zum Kühlen von Rechenvorrichtungen nach irgendeinem der vorhergehenden Ansprüche, wobei eine, mehrere, oder bevorzugt alle Rechenvorrichtungen aus der ersten und/oder zweiten und/oder, wenn das System ein System nach Anspruch 2 ist, der dritten Menge von Rechenvorrichtungen jeweils einen eigenen Ventilator aufweist/aufweisen.

9. System beziehungsweise Verfahren zum Kühlen von Rechenvorrichtungen nach Anspruch 8, wobei der Ventilator durch die entsprechende Rechenvorrichtung selbst geregelt wird.

10. System beziehungsweise Verfahren zum Kühlen von Rechenvorrichtungen nach irgendeinem der vorhergehenden Ansprüche, wobei wenn das System ein System nach Anspruch 2 ist, die dritte Menge von Rechenvorrichtungen oberhalb der zweiten Menge von Rechenvorrichtungen angeordnet ist.

11. System beziehungsweise Verfahren zum Kühlen von Rechenvorrichtungen nach irgendeinem der vorhergehenden Ansprüche, wobei die Kühlluftquelle einen Wärmetauscher umfasst.

12. System beziehungsweise Verfahren zum Kühlen von Rechenvorrichtungen nach irgendeinem der vorhergehenden Ansprüche, wobei Luft mit der ersten Temperatur über eine erste Umgehung in den Raum mit der Luft mit der zweiten Temperatur gelangen kann und/oder Luft aus dem Raum mit der Luft mit der zweiten Temperatur über eine zweite Umgehung hinter die zweite Menge von Rechenvorrichtungen gelangen kann und/oder, wenn das System ein System nach Anspruch 2 ist, Luft mit der zweiten Temperatur über eine dritte Umgehung in den Raum mit der Luft mit der dritten Temperatur gelangen kann und/oder Luft aus dem Raum mit der Luft mit der dritten Temperatur über eine vierte Umgehung hinter die dritte Menge von Rechenvorrichtungen gelangen kann.

13. System beziehungsweise Verfahren zum Kühlen von Rechenvorrichtungen nach irgendeinem der vorhergehenden Ansprüche, wobei die erste und/oder zweite, und/oder, wenn das System ein System nach Anspruch 2 ist, die dritte und/oder vierte Umgehung ein Regelventil aufweisen.

14. System beziehungsweise Verfahren zum Kühlen von Rechenvorrichtungen nach irgendeinem der vorhergehenden Ansprüche, wobei die Temperatur der Luft mit der ersten Temperatur mindestens 1 °C, bevorzugt mindestens 2 °C, weiter bevorzugt mindestens 4 °C, weiter bevorzugt mindestens 6 °C und am meisten bevorzugt mindestens 10 °C geringer ist, als die Temperatur der Luft mit der zweiten Temperatur und/oder, wenn das System ein System nach Anspruch 2 ist, die Temperatur der Luft mit der zweiten Temperatur mindestens 1 °C, bevorzugt mindestens 2 °C, weiter bevorzugt mindestens 4 °C, weiter bevorzugt mindestens 6 °C und am meisten bevorzugt mindestens 10 °C geringer ist, als die Temperatur der Luft mit der dritten Temperatur.

15. System beziehungsweise Verfahren zum Kühlen von Rechenvorrichtungen nach irgendeinem der vorhergehenden Ansprüche, wobei der Raum mit der Luft mit der zweiten Temperatur so umbaut ist, dass mindestens 60% der Luft, bevorzugt mindestens 70%, weiter bevorzugt mindestens 80%, am meisten bevorzugt mindestens 90 % die während des Betriebs des Systems bzw. der Durchführung des Verfahrens in den Raum eindringt, durch einen ersten definierten Lufteinlass in diesen eindringt und/oder mindestens 60% der Luft, bevorzugt mindestens 70%, weiter bevorzugt mindestens 80%, die während des Betriebs des Systems bzw. der Durchführung des Verfahrens den Raum verlässt, diesen durch einen ersten definierten Luftauslass verlässt, und/oder, wenn das System ein System nach Anspruch 2 ist, der Raum mit der Luft mit der dritten Temperatur so umbaut ist, dass mindestens 60% der Luft, bevorzugt mindestens 70%, weiter bevorzugt mindestens 80%, am meisten bevorzugt mindestens 90 % die während des Betriebs des Systems in den Raum eindringt, durch einen zweiten definierten Lufteinlass in diesen eindringt und/oder mindestens 60% der Luft, bevorzugt mindestens 70%, weiter bevorzugt mindestens 80%, die während des Betriebs des Systems den Raum verlässt, diesen durch einen zweiten definierten Luftauslass verlässt.
